# EUROPEAN PATENT APPLICATION

(11) **EP 4 486 086 A1**
(43) Date of publication of application: **01.01.2025**
(21) Application number: 23214641.5
(22) Date of filing: 06.12.2023
(51) Int. Cl.: H10B 12/00

(54) **THREE-DIMENSIONAL FLOATING BODY MEMORY**

(30) Priority: 27.06.2023 US 202318341852
(71) Applicant: Intel Corporation, Santa Clara, CA 95054 (US)
(72) Inventor: SHARMA, Abhishek Anil, Portland 97229 (US); GOMES, Wilfred, Portland 97229 (US); GHANI, Tahir, Portland 97229 (US); MURTHY, Anand S., Portland 97229 (US); SUTHRAM, Sagar, Portland 97229 (US)
(74) Representative: HGF

(57) **Abstract**

Integrated circuit (IC) devices implementing three-dimensional (3D) floating body memory are disclosed. An example IC device includes a floating body memory cell comprising a transistor having a first source or drain (S/D) region, a second S/D region, and a gate over a channel portion between the first and second S/D regions; a BL coupled to the first S/D region and parallel to a first axis of a Cartesian coordinate system; a SL coupled to the second S/D region and parallel to a second axis of the coordinate system; and a WL coupled to or being a part of the gate and parallel to a third axis of the coordinate system. IC devices implementing 3D floating body memory as described herein may be used to address the scaling challenges of conventional memory technologies and enable high-density embedded memory compatible with advanced CMOS processes.

## Description

### Background

Embedded memory is important to the performance of modern system-on-a-chip (SoC) technology. Low-power and high-density embedded memory is used in many different computer products and further improvements are always desirable. Floating body memory, e.g., floating body dynamic random-access memory (FBDRAM) is a popular choice for various types of computer systems.

### Brief Description of the Drawings

Embodiments will be readily understood by the following detailed description in conjunction with the accompanying drawings.
FIG. 1 provides a perspective view of an example integrated circuit (IC) device implementing a nanoribbon-based field-effect transistor (FET), according to some embodiments of the present disclosure.
FIGS. 2-3 are electric circuit diagrams of two example arrays of floating body memory cells, according to some embodiments of the present disclosure.
FIG. 4 is a cross-sectional side view of an example IC device implementing three-dimensional (3D) floating body memory according to the electric circuit diagram of FIG. 2, according to some embodiments of the present disclosure.
FIGS. 5-8 are cross-sectional side views of example IC devices implementing 3D floating body memory according to the electric circuit diagram of FIG. 3, according to some embodiments of the present disclosure.
FIG. 9 provides top views of a wafer and dies that may include one or more IC devices implementing 3D floating body memory in accordance with any of the embodiments disclosed herein.
FIG. 10 is a cross-sectional side view of an IC package that may include one or more IC devices implementing 3D floating body memory in accordance with any of the embodiments disclosed herein.
FIG. 11 is a cross-sectional side view of an IC device assembly that may include one or more IC devices implementing 3D floating body memory in accordance with any of the embodiments disclosed herein.
FIG. 12 is a block diagram of an example computing device that may include 3D floating body memory in accordance with any of the embodiments disclosed herein.
FIG. 13 is a block diagram of an example processing device that may include 3D floating body memory in accordance with any of the embodiments disclosed herein.

### Detailed Description

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

For purposes of illustrating IC devices implementing 3D floating body memory as described herein, it might be useful to first understand phenomena that may come into play in certain IC arrangements. The following foundational information may be viewed as a basis from which the present disclosure may be properly explained. Such information is offered for purposes of explanation only and, accordingly, should not be construed in any way to limit the broad scope of the present disclosure and its potential applications.

Some memory devices may be considered "standalone" devices in that they are included in a chip that does not also include compute logic (where, as used herein, the term "compute logic devices" or simply "compute logic" or "logic devices," refers to IC components, e.g., transistors, for performing computing/processing operations). Other memory devices may be included in a chip along with compute logic and may be referred to as "embedded" memory devices. Using embedded memory to support compute logic may improve performance by bringing the memory and the compute logic closer together and eliminating interfaces that increase latency. Various embodiments of the present disclosure relate to embedded memory arrays, as well as corresponding methods and devices.

Access transistors have been used in the past to realize memory where each memory cell includes one capacitor for storing a memory state (e.g., logical "1" or "0") of the cell and an access transistor controlling access to the cell (e.g., access to write information to the cell or access to read information from the cell). Such a memory cell may be referred to as a "1T-1C memory cell," highlighting the fact that it uses one access transistor (i.e., "1T" in the term "1T-1C memory cell") and one capacitor (i.e., "1C" in the term "1T-1C memory cell"). One capacitor electrode of the capacitor of a 1T-1C memory cell may be coupled to either a source or a drain (S/D) terminal/region of the access transistor (e.g., to the source terminal/region of the access transistor), while the other S/D terminal/region of the access transistor (e.g., to the drain terminal/region) may be coupled to a bitline, a gate terminal of the access transistor may be coupled to a wordline, and the other capacitor electrode of the capacitor may be coupled to a plateline. Since such a memory cell can be fabricated with as little as a single access transistor, it can provide higher density and lower standby power versus some other types of memory in the same process technology.

Floating body memory is even simpler than 1T-1C memory in that it only uses a single transistor as a memory cell. In floating body memory, a memory cell (also referred to as a "floating body memory cell") may use the floating body of a single transistor to store data, which, compared to 1T-1C memory, eliminates the need to use a capacitor to store charge representing a memory state. In a floating body memory cell, a first S/D terminal is coupled to a bitline (BL), a second S/D terminal is coupled to a selectline (SL), and a gate terminal of the transistor is coupled to a wordline (WL). In this context, as used herein, the term "coupled" may mean a direct electrical connection (as opposed to, e.g., capacitive coupling), possibly via an intermediate conductive structure (e.g., a conductive via) that has one portion in electrical and physical contact with a terminal of the transistor and another portion in electrical and physical contact with the WL, BL, or SL. As used herein, A and B may be described to be in physical contact if one or more interfacial layers that may form when A and B are brought into physical contact is considered to be a part of A and/or a part of B. One of the first and second S/D terminals/regions of a transistor of a floating body memory cell may be a source terminal/region, and the other one may be a drain terminal/region. Because the designation of "source" and "drain" in a transistor may be interchangeable, which control line is a BL and which control line is a SL is also interchangeable. Therefore, in general, the BL, SL, and WL may be referred to as, respectively, first, second, and third control lines for controlling a floating body memory cell.

In some deployment scenarios, floating body memory cells may be more advantageous than traditional memory cells, given their simple structure and high scalability. One challenge resides in that, given a usable surface area of a support structure such as a substrate, a die, a wafer, or a chip, there are only so many floating body memory cells that can be formed in that area, placing a limitation on the density of floating body memory arrays. In conventional solutions, attempts to increase memory density have included decreasing the critical dimensions of individual components of memory cells (e.g., decreasing transistor dimensions), which requires ever-increasing process complexity and cost, resulting in diminishing returns and expected slow pace of memory scaling for future nodes.

Embodiments of the present disclosure may improve on at least some of the challenges and issues described above by increasing the number of active memory layers, to generate a vertically stacked floating body memory design using fewer masks and at a lower cost. In particular, embodiments of the present disclosure are based on using either structures of semiconductor materials stacked above one another above a support structure or vertical transistors to realize high-density 3D floating body memory. In the context of the present disclosure, the term "above" may refer to being further away from the support structure of an IC device, while the term "below" refers to being closer towards the support structure of the IC device. Two 3D floating body memory designs are presented herein. The first design is based on using vertical transistors (i.e., on using transistors where a channel region extends in a direction substantially perpendicular to the support structure) to realize 3D floating body memory where, for a given floating body memory cell, different ones of the WL, BL, and SL are parallel to different axes of a Cartesian coordinate system. An example IC device according to the first design includes a floating body memory cell comprising a transistor having a first S/D region, a second S/D region, and a gate over a channel portion between the first and second S/D regions; a BL coupled (e.g., directly connected ) to the first S/D region and parallel to a first axis of a Cartesian coordinate system; a SL coupled (e.g., directly connected ) to the second S/D region and parallel to a second axis of the coordinate system; and a WL coupled (e.g., directly connected ) to or being a part of the gate and parallel to a third axis of the coordinate system. The second design is based on using horizontal transistors (i.e., on using transistors where a channel region extends in a plane substantially parallel to the support structure) to realize 3D floating body memory where, for a given floating body memory cell, all of the WL, BL, and SL are substantially parallel to the support structure, the BL and the SL are parallel to one another and perpendicular to the WL (i.e., different ones of the WL, BL, and SL are parallel to only two of the three different axes of a Cartesian coordinate system). An example IC device according to the second design includes a support structure; a semiconductor material in a layer substantially parallel to the support structure; first, second, third, and fourth transistors having channel regions in different portions of the semiconductor material; first, second, third, and fourth WLs coupled (e.g., directly connected ) to, respectively, gates of the first, second, third, and fourth transistors; a shared BL coupled (e.g., directly connected ) to a first S/D region of each of the first, second, third, and fourth transistors; and a shared SL coupled (e.g., directly connected ) to a second S/D region of each of the first, second, third, and fourth transistors, where the first, second, third, and fourth WLs are substantially parallel to one another and to the support structure and where the shared BL and SL are substantially parallel to one another and to the support structure and substantially perpendicular to the first, second, third, and fourth WLs.

Incorporating different floating body memory cells in different layers with respect to a support structure may allow significantly increasing density of memory cells in a memory array having a given footprint area (the footprint area being defined as an area in a plane of the support structure, or a plane parallel to the plane of the support structure, i.e., the x-y plane of the example coordinate system shown in the present drawings), or, conversely, allow significantly reducing the footprint area of the memory array with a given density of memory cells. IC devices implementing 3D floating body memory as described herein may be used to address the scaling challenges of conventional memory technologies and enable high-density embedded memory compatible with advanced complementary metal-oxide-semiconductor (CMOS) processes. Other technical effects will be evident from various embodiments described here.

In the following detailed description, various aspects of the illustrative implementations may be described using terms commonly employed by those skilled in the art to convey the substance of their work to others skilled in the art. For example, some descriptions may refer to a particular S/D region of a transistor being either a source region or a drain region. However, unless specified otherwise, which region of a transistor is considered to be a source region and which region is considered to be a drain region is not important because, as is common in the field of FETs, designations of source and drain are often interchangeable. Therefore, descriptions of some illustrative embodiments of the source and drain regions provided herein are applicable to embodiments where the designation of source and drain regions may be reversed. Furthermore, in context of S/D regions, the term "region" may be used interchangeably with the terms "contact" and "terminal" of a transistor.

As used herein, the term "connected" means a direct electrical or magnetic connection between the things that are connected, without any intermediary devices, while the term "coupled" means either a direct electrical or magnetic connection between the things that are connected, or an indirect connection through one or more passive or active intermediary devices. The term "circuit" means one or more passive and/or active components that are arranged to cooperate with one another to provide a desired function. If used, the terms "oxide," "carbide," "nitride," etc. refer to compounds containing, respectively, oxygen, carbon, nitrogen, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/- 20%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, analogous elements designated in the present drawings with different reference numerals after a dash, e.g., first and second S/D regions 114-1, 114-2 may be referred to together without the reference numerals after the dash, e.g., as "S/D regions 114." In order to not clutter the drawings, if multiple instances of certain elements are illustrated, only some of the elements may be labeled with a reference sign.

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of IC devices implementing 3D floating body memory as described herein.

Various IC devices implementing 3D floating body memory as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

In general, floating body memory cells may include transistors of any architecture, e.g., of any planar or non-planar architecture. Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surfaces. A confinement surface refers to a particular orientation of the channel surface that is confined by the gate field. Non-planar transistors potentially improve performance relative to transistors having a planar architecture, such as single-gate transistors.

Nanoribbon-based transistors may be particularly advantageous for continued scaling of CMOS technology nodes due to the potential to form gates on all four sides of a channel material (hence, such transistors are sometimes referred to as "gate all around" transistors). As used herein, the term "nanoribbon" refers to an elongated structure of a semiconductor material having a longitudinal axis parallel to a support structure (e.g., a substrate, a die, a chip, or a wafer; also referred to herein as, simply, "support") over which such a structure is built. Typically, a length of a such a structure (i.e., a dimension measured along the longitudinal axis, shown in the present drawings to be along the y-axis of an example x-y-z coordinate system) is greater than each of a width (i.e., a dimension measured along the x-axis of the example coordinate system shown in the present drawings) and a thickness/height (i.e., a dimension measured along the z-axis of the example coordinate system shown in the present drawings). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A transistor may then be described as a "nanoribbon-based transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain (S/D) regions of a transistor provided on either side of the channel material.

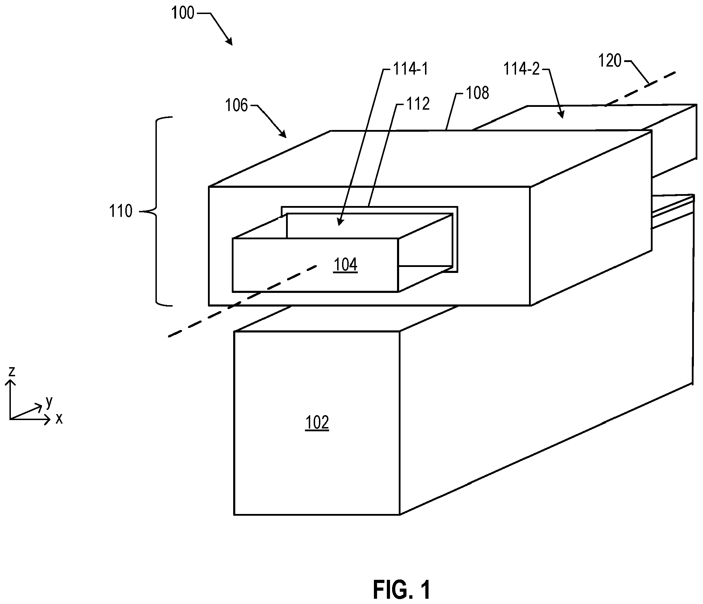

FIG. 1 provides a perspective view of an example IC device 100 with a nanoribbon-based transistor 110, according to some embodiments of the present disclosure. As shown in FIG. 1, the IC device 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2 (together referred to as "S/D regions 114"), on either side of the gate stack 106. One of the S/D regions 114 is a source region and the other one is a drain region. However, because, as is common in the field of FETs, designations of source and drain are often interchangeable, they are simply referred to herein as a first S/D region 114-1 and a second S/D region 114-2.

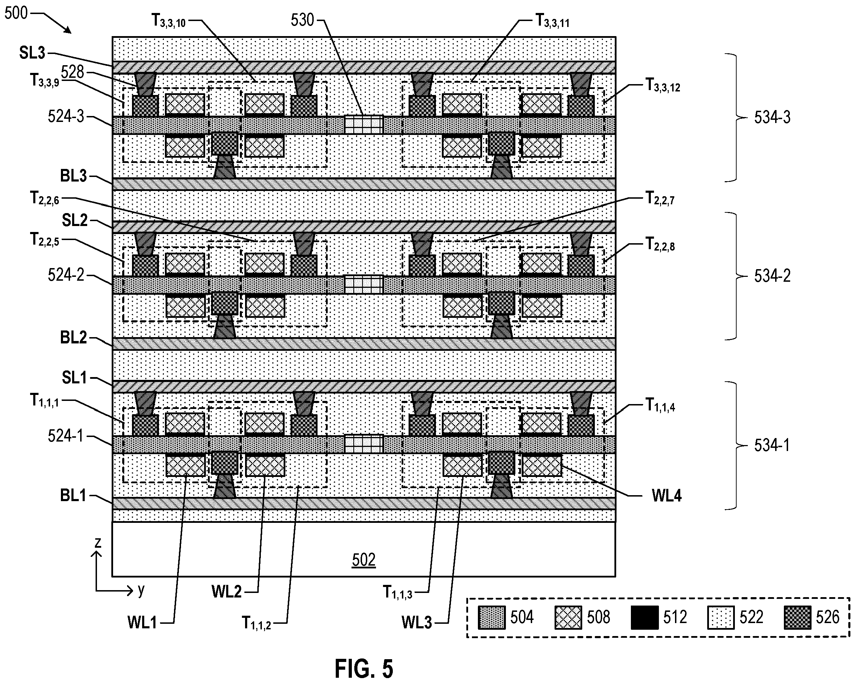

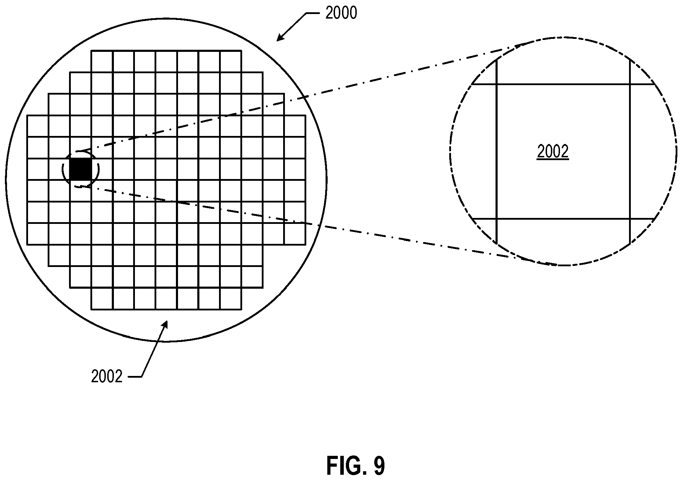

Implementations of the present disclosure may be formed or carried out on any suitable support 102, such as a substrate, a die, a wafer, or a chip. The support 102 may, e.g., be the wafer 2000 of FIG. 9, discussed below, and may be, or be included in, a die, e.g., the singulated die 2002 of FIG. 9, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC structure with 3D floating body memory as described herein may be built falls within the spirit and scope of the present disclosure. Although only one nanoribbon 104 is shown in FIG. 1, the IC device 100 may include a stack of such nanoribbons where a plurality of nanoribbons 104 are stacked above one another, e.g., as is shown in FIGS. 5-6 showing IC devices with 3D floating body memory implemented using nanoribbon-based transistors such as the transistor 110. In some embodiments, a portion of the support 102 right below the lowest nanoribbon 104 of the stack may be shaped as a subfin extending away from a base, as is known in the field of nanoribbon-based transistors.

The nanoribbon 104 may take the form of a nanowire or nanoribbon, for example. In some embodiments, an area of a transversal cross-section of the nanoribbon 104 (i.e., an area in the x-z plane of the example coordinate system x-y-z shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width of the nanoribbon 104 (i.e., a dimension measured in a plane parallel to the support 102 and in a direction perpendicular to the longitudinal axis 120 of the nanoribbon 104, e.g., along the y-axis of the example coordinate system shown in FIG. 1) may be at least about 3 times larger than a height of the nanoribbon 104 (i.e., a dimension measured in a plane perpendicular to the support 102, e.g., along the z-axis of the example coordinate system shown in FIG. 1), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back end fabrication to avoid damaging other components, e.g., front end components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include at least one P-type work function metal or N-type work function metal, depending on whether the transistor of which it is a part is to be a PMOS or an NMOS transistor. For example, a P-type work function metal may be used as the gate electrode material 108 when the transistor 110 is a PMOS transistor and an N-type work function metal may be used as the gate electrode material 108 when the transistor 110 is an NMOS transistor. For a PMOS transistor, metals that may be used for the gate electrode material 108 may include, but are not limited to, ruthenium, palladium, platinum, cobalt, nickel, and conductive metal oxides (e.g., ruthenium oxide). For an NMOS transistor, metals that may be used for the gate electrode material 108 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 108 may include a stack of two or more metal layers, where one or more metal layers are work function metal layers and at least one metal layer is a fill metal layer. Further metal layers may be included for other purposes, such as a barrier layer (e.g., tantalum, tantalum nitride, an aluminum-containing alloy, etc.). In some embodiments, a gate electrode material 108 may include a resistance-reducing cap layer (e.g., copper, gold, cobalt, or tungsten). Further layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabricate of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and source/drain contacts of the transistor 110 and could be made of a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass. A gate spacer may include pores or air gaps to further reduce its dielectric constant.

In some embodiments, e.g., when the transistor 110 is a storage transistor of a hysteretic memory cell (i.e., a type of memory that functions based on the phenomenon of hysteresis), the gate insulator 112 may be replaced with, or complemented by, a hysteretic material. In some embodiments, a hysteretic material may be provided as a layer of a ferroelectric (FE) or an antiferroelectric (AFE) material. Such an FE/AFE material may include one or more materials that can exhibit sufficient FE/AFE behavior even at thin dimensions, e.g., such as an insulator material at least about 10% of which is in an orthorhombic phase or a tetragonal phase (e.g., as a material in which at most about 90% of the material may be amorphous or in a monoclinic phase). Some examples of such materials include materials that include hafnium, oxygen, and zirconium (e.g., hafnium zirconium oxide (HfZrO, also referred to as HZO)), materials that include hafnium, oxygen, and silicon (e.g., silicon-doped (Si-doped) hafnium oxide), materials that include hafnium, oxygen, and germanium (e.g., germanium-doped (Ge-doped) hafnium oxide), materials that include hafnium, oxygen, and aluminum (e.g., aluminum-doped (Al-doped) hafnium oxide), and materials that include hafnium, oxygen, and yttrium (e.g., yttrium-doped (Y-doped) hafnium oxide). However, in other embodiments, any other materials which exhibit FE/AFE behavior at thin dimensions may be used to replace, or to complement, the gate insulator 112, and are within the scope of the present disclosure. The FE/AFE material included in the gate stack 106 may have a thickness that may, in some embodiments, be between about 0.5 nanometers and 10 nanometers, including all values and ranges therein (e.g., between about 1 and 8 nanometers, or between about 0.5 and 5 nanometers). In other embodiments, a hysteretic material may be provided as a stack of materials that, together, exhibit hysteretic behavior. Such a stack may include, e.g., a stack of silicon oxide and silicon nitride. Unless specified otherwise, descriptions provided herein with respect to the gate insulator 112 are equally application to embodiments where the gate insulator 112 is replaced with, or complemented by, a hysteretic material.

Turning to the S/D regions 114 of the transistor 110, in some embodiments, the S/D regions may be highly doped, e.g., with dopant concentrations of about 10²¹ cm⁻³, in order to advantageously form Ohmic contacts with the respective S/D electrodes (not shown in FIG. 1), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. Even with doped to realize threshold voltage tuning as described herein, the channel portions of transistors typically include semiconductor materials with doping concentrations significantly smaller than those of the S/D regions 114.

The S/D regions 114 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114. An epitaxial deposition process may then be carried out to fill the recesses with material that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. And in further embodiments, one or more layers of metal and/or metal alloys may be used to form the S/D regions 114. In some embodiments, a distance between the first and second S/D regions 114 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC device 100 shown in FIG. 1, as well as IC devices/structures shown in other drawings of the present disclosure, is intended to show relative arrangements of some of the components therein, and the IC device 100, or portions thereof, may include other components that are not illustrated (e.g., electrical contacts to the S/D regions 114 of the transistor 110, additional layers such as a spacer layer around the gate electrode of the transistor 110, etc.). For example, although not specifically illustrated in FIG. 1, a dielectric spacer may be provided between a first S/D electrode (which may also be referred to as a "first S/D contact") coupled to a first S/D region 114-1 of the transistor 110 and the gate stack 106 as well as between a second S/D electrode (which may also be referred to as a "second S/D contact") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material.

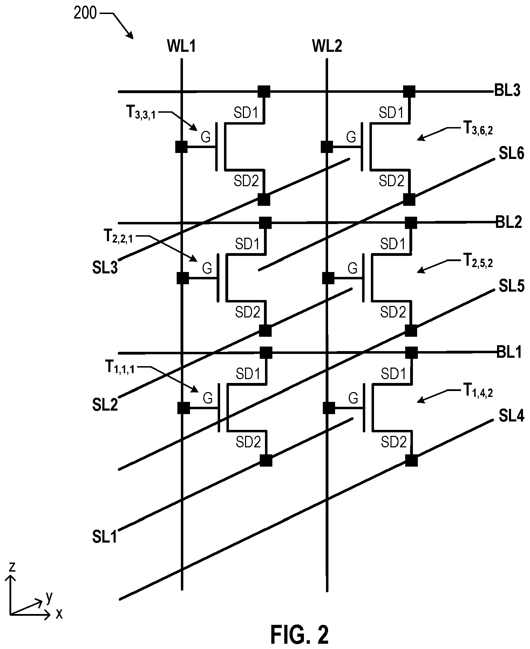

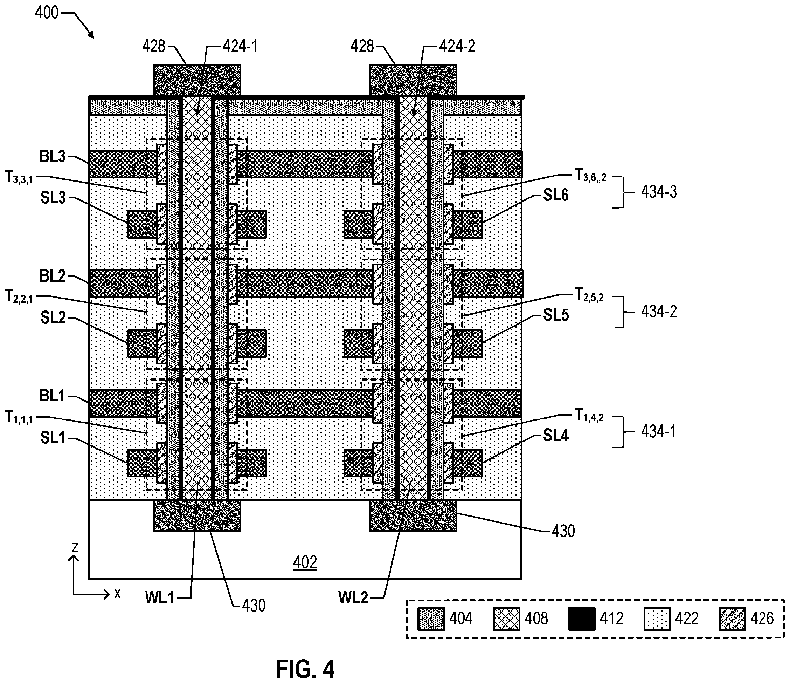

FIGS. 2-3 are electric circuit diagrams of two example arrays of floating body memory cells, according to some embodiments of the present disclosure. In each of FIGS. 2-3, individual transistors of different floating body memory cells are labeled as transistors T_{BL,SL,WL}, where the indices BL, SL, and WL indicate the respective BL, SL, and WL to which a transistor T is coupled to. For example, a transistor T_{1,1,1} is coupled to BL1, SL1, and WL1, and so on. Each of the transistors T may be a FET (e.g., a transistor 110 as described above), having a gate terminal, a source terminal, and a drain terminal, labeled in FIGS. 2-3 as terminals G, S, and D, respectively. For each transistor T, a BL is coupled to a first S/D terminal/region of the transistor (e.g., to the first S/D region 114-1 as described above), an SL is coupled to a second S/D terminal/region of the transistor (e.g., to the second S/D region 114-2 as described above), and a WL is coupled to a gate (e.g., to the gate electrode material 108 as described above)of the transistor. Although a particular number of transistors, BLs, SLs, and WLs are shown in FIGS. 2-3, as well as in IC devices of FIGS. 4-8 showing example implementations of the electric circuit diagrams of FIGS. 2-3, in other embodiments, any suitable number of transistors, BLs, SLs, and WLs may be used in a 3D floating body memory in accordance with the principles described herein.

FIG. 2 illustrates an array 200 where, for a given floating body memory cell (represented by different ones of the transistors T shown in FIG. 2), different ones of the WL, BL, and SL are parallel to different axes of a Cartesian coordinate system. For example, FIG. 2 illustrates that all of the BLs are parallel to the x-axis of the example x-y-z coordinate system shown, all SLs are parallel to the y-axis, and all WLs are parallel to the z-axis. In the array 200, some of the transistors T may be coupled to a single (i.e., shared) WL, while being coupled to different BLs and SLs. For example, as shown in FIG. 2, the transistors T_{1,1,1}, T_{2,2,1}, and T_{3,3,1} are coupled to a shared WL1 (where the transistor T_{1,1,1} is further coupled to BL1 and SL1, the transistor T_{2,2,1} is further coupled to BL2 and SL2, and the transistor T_{3,3,1} is further coupled to BL3 and SL3), while the transistors T_{1,4,2}, T_{2,5,2}, and T_{3,6,2} are coupled to a shared WL2 (where the transistor T_{1,4,2} is further coupled to BL1 and SL4, the transistor T_{2,5,2} is further coupled to BL2 and SL5, and the transistor T_{3,6,2} is further coupled to BL3 and SL6). Furthermore, in the array 200, some of the transistors T may be coupled to a single (i.e., shared) BL, while being coupled to different SLs and WLs. For example, as shown in FIG. 2, the transistors T_{1,1,1} and T_{1,4,2} are coupled to a shared BL1 (where the transistor T_{1,1,1} is further coupled to SL1 and WL1, and the transistor T_{1,4,2} is further coupled to SL4 and WL2), the transistors T_{2,2,1} and T_{2,5,2} are coupled to a shared BL2 (where the transistor T_{2,2,1} is further coupled to SL2 and WL1, and the transistor T_{2,5,2} is further coupled to SL5 and WL2), and the transistors T_{3,3,1} and T_{3,6,2} are coupled to a shared BL3 (where the transistor T_{3,3,1} is further coupled to SL3 and WL1, and the transistor T_{3,6,2} is further coupled to SL6 and WL2). In some embodiments, the array 200 may extend further along the y-axis by including additional two-dimensional (2D) planes similar to that shown in FIG. 2, containing additional 2D sub-arrays of floating body memory cells. In such embodiments, some of the transistors T may be coupled to a single (i.e., shared) SL, while being coupled to different BLs and WLs. For example, although not shown in FIG. 2, the transistor T_{1,1,1} and one or more further transistors in other x-z planes may be coupled to a shared SL1 while being coupled to different BLs and WLs.

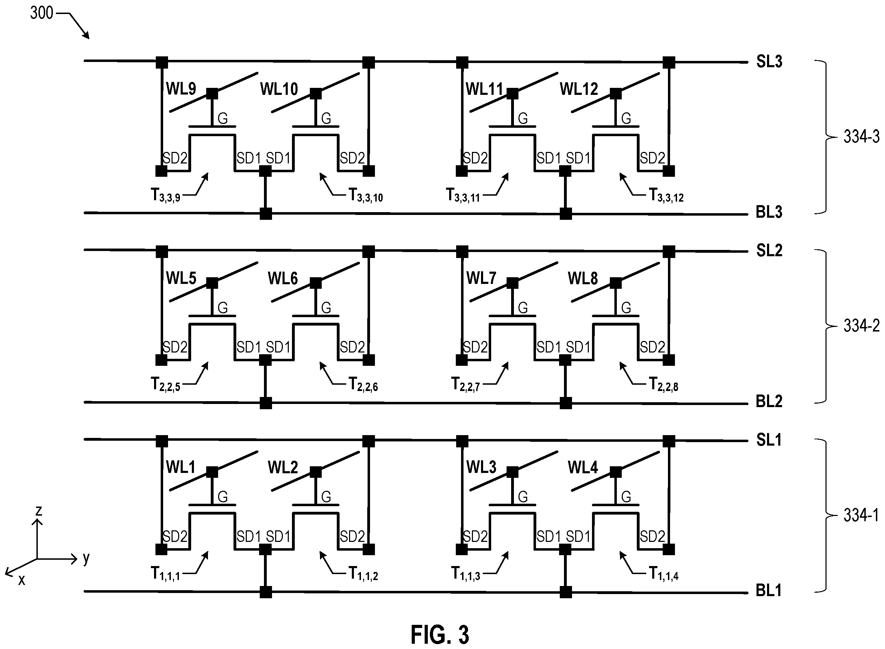

FIG. 3 illustrates an array 300 where, for a given floating body memory cell (represented by different ones of the transistors T shown in FIG. 3), all of the WL, BL, and SL are in a layer parallel to an x-y plane of an example Cartesian coordinate system shown in the present drawings (i.e., parallel to a support structure over which the array 300 is provided), where BLs and SLs are substantially parallel to one another, and SL is substantially perpendicular to the BLs and SLs. For example, FIG. 3 illustrates that all of the WLs are parallel to the x-axis of the example x-y-z coordinate system shown, while all BLs and all SLs are parallel to the y-axis. In the array 300, some of the transistors T may be coupled to a single (i.e., shared) BL and, at the same time, also coupled to a single (i.e., shared) SL, while being coupled to different WLs. For example, as shown in FIG. 3, each of the transistors T_{1,1,1}, T_{1,1,2}, T_{1,1,3}, and T_{1,1,4} is coupled to a shared BL1 and a shared SL1, while being coupled to, respectively, WL1, WL2, WL3, and WL4. In another example, as shown in FIG. 3, each of the transistors T_{2,2,5}, T_{2,2,6}, T_{2,2,7}, and T_{2,2,8} is coupled to a shared BL2 and a shared SL2, while being coupled to, respectively, WL5, WL6, WL7, and WL8. In yet another example, as shown in FIG. 3, each of the transistors T_{3,3,9}, T_{3,3,10}, T_{3,3,11}, and T_{3,3,12} is coupled to a shared BL3 and a shared SL3, while being coupled to, respectively, WL9, WL10, WL11, and WL12. In some embodiments, all of the transistors coupled to a pair of a BL and an SL may be arranged in a respective layer 334 above the support structure, where different layers 334 may be vertically stacked above one another (i.e., stacked in the direction of the z-axis of the example coordinate system shown). This is shown in FIG. 3, illustrating that the transistors T_{1,1,1}, T_{1,1,2}, T_{1,1,3}, and T_{1,1,4} coupled to a shared BL1 and a shared SL1 are provided in a layer 334-1, the transistors T_{2,2,5}, T_{2,2,6}, T_{2,2,7}, and T_{2,2,8} coupled to a shared BL2 and a shared SL2 are provided in a layer 334-2, and the transistors T_{3,3,9}, T_{3,3,10}, T_{3,3,11}, and T_{3,3,12} coupled to a shared BL3 and a shared SL3 are provided in a layer 334-3. The layers 334 may be parallel to one another and parallel to the support structure over which the memory array 300 is provided. Individual layers 334 may be seen as two-dimensional (2D) sub-arrays of floating body memory cells.

Furthermore, in some embodiments of the array 300, pairs of adjacent transistors in a given layer 334 may share a S/D region that is coupled to a BL or an SL. For example, in the first layer 334-1, the transistors T_{1,1,1} and T_{1,1,2} may share their first S/D region (SD1) that is coupled to the shared BL1, and so may the transistors T_{1,1,3} and T_{1,1,4}. In another example, in the second layer 334-2, the transistors T_{2,2,5} and T_{2,2,6} may share their first S/D region that is coupled to the shared BL2, and so may the transistors T_{2,2,7} and T_{2,2,8}. Similarly, in the third layer 334-3, the transistors T_{3,3,9} and T_{3,3,10} may share their first S/D region that is coupled to the shared BL3, and so may the transistors T_{3,3,11} and T_{3,3,12}. Although not specifically shown, in other embodiments of the array 300, adjacent transistors may share their second S/D region (SD2) that is coupled to the shared SL.

FIGS. 4-8 show example implementations of IC devices according to the electric circuit diagrams of FIGS. 2-3. In particular, FIG. 4 is a cross-sectional side view of an example IC device implementing 3D floating body memory according to the electric circuit diagram of FIG. 2, while FIGS. 5-8 are cross-sectional side views of example IC devices implementing 3D floating body memory according to the electric circuit diagram of FIG. 3, according to various embodiments of the present disclosure. A number of elements referred to in the description of FIGS. 4-8 with reference numerals are illustrated in these drawings with different patterns, with a legend showing the correspondence between the reference numerals and patterns being provided at the bottom of each drawing page containing FIGS. 4-8. For example, the legend illustrates that FIGS. 4-8 use different patterns to show a support structure 402, a channel material 404, a gate electrode material 408, a gate insulator material 412, and so on.

Turning to FIG. 4, an IC device 400 is shown, where the IC device 400 includes a support structure 402 and an insulator material 422 over the support structure 402. The support structure 402 may be an example of the support structure 102, described above. The insulator material 422 may include any suitable insulator materials described above, e.g., any suitable ILD material as described above. FIG. 4 further illustrates two openings 424-1 and 424-2 extending from the top of the insulator material 422 towards the support structure 402. In some embodiments, the openings 424 may be vias. While FIG. 4 illustrates that the openings 424 extend through all of the insulator material 422, stopping at the support structure 402, in other embodiments of the IC device 400 this may not be the case and the openings 424 may end somewhere within the insulator material 422 without reaching the support structure 402. As shown in FIG. 4, a channel material 404 may be deposited to line sidewalls of the openings 424. Material composition and thickness of the channel material 404 may be as described above with reference to thin-film channel materials that may be included in the transistor 110.

Once the channel material 404 has been deposited on the sidewalls of the openings 424, the sidewalls may further be lined with a gate insulator material 412 and then the remainder of the openings 424 may be filled with a gate electrode material 408. The gate material 412 and the gate electrode material 408 may be analogous to the gate material 112 and the gate electrode material 108 as described above with reference to the transistor 110. Although the same gate electrode material 408 is illustrated in both of the openings 424, in various embodiments, material compositions of the gate electrode materials 408 in different openings 424 may, but do not have to be, the same. Similarly, although the same channel material 404 and the gate insulator material 412 are illustrated to line sidewalls of both of the openings 424, in various embodiments, material compositions of the channel materials 404 in different openings 424 may, but do not have to be, the same, and material compositions of the gate insulator materials 412 in different openings 424 may, but do not have to be, the same. Because the channel material 404 and the gate insulator material 412 are deposited to line sidewalls of the openings 424 and then the openings 424 are filled with the gate electrode material 408, in the IC device 400, for each of the openings 424, the gate insulator material 412 may be a liner enclosing the gate electrode material 408, and the channel material 404 may be a liner enclosing the gate insulator material 412.

FIG. 4 further illustrates a S/D interface material 426 that may be provided at an interface between S/D regions of the transistors formed based on the channel material 404 and respective BLs and SLs coupled to these S/D regions. The S/D interface material 426 may be any suitable electrically conductive material, provided because material composition of the BLs and SLs of the IC device 400 may not be ideal for providing suitable contacts to S/D regions of the transistors of various floating body memory cells and the S/D interface material 426 may be used to ensure better contacts. In other embodiments of the IC device 400, the S/D interface material 426 may be absent at one or more points where the BLs and SLs of the IC device 400 need to make electrical contact with S/D regions of various transistors. When present, the S/D interface material 426 may be a liner enclosing the S/D regions in the channel material 404 around the openings 424.

The IC device 400 of FIG. 4 is an example of the array 200 of FIG. 2 and, therefore, individual transistors T and control lines (i.e., BLs, SLs, and WLs) are labeled in FIG. 4 using the same notation as that used in FIG. 2 and descriptions provided with respect to FIG. 2 are applicable to FIG. 4 and, in the interests of brevity, are not repeated. FIG. 4 illustrates different rectangles to highlight approximate boundaries of different transistors. In the IC device 400, the electrically conductive materials used as the gate electrode materials 408 in the openings 424 provide respective WLs, i.e., WL1 is formed by the gate electrode material 408 in the opening 424-1 and WL2 is formed by the gate electrode material 408 in the opening 424-2. Thus, in the IC device 400, the WLs extend in a direction substantially perpendicular to the support structure 402. On the other hand, the BLs and the SLs extend in directions substantially parallel to the support structure 402, where the BLs are perpendicular to the SLs. Each of the transistors of various floating body memory cells of the IC device 400 are vertical transistors, because the gate length (i.e., a distance between the first and second S/D regions of a transistor) is measured in the vertical direction (i.e., in a direction substantially perpendicular to the support structure 402).

FIG. 4 illustrates that, in some embodiments, transistors of the array 200 that are coupled to a single WL may be provided based on the channel material 404 deposited on sidewalls of a single opening 424, where different ones of these transistors have channel regions in different portions of that channel material 404. Thus, FIG. 4 illustrates that, in some embodiments, transistors of the array 200 that are coupled to a single WL may be vertically stacked above one another. For example, FIG. 4 illustrates that the transistors T_{1,1,1}, T_{2,2,1}, and T_{3,3,1}, coupled to a shared WL1, may be vertically stacked above one another and may have their channel regions in different portions of the channel material 404 on sidewalls of the opening 424-1. Similarly, FIG. 4 illustrates that the transistors T_{1,4,2}, T_{2,5,2}, and T_{3,6,2}, coupled to a shared WL2, may be vertically stacked above one another and may have their channel regions in different portions of the channel material 404 on sidewalls of the opening 424-2.

FIG. 4 further illustrates that, in some embodiments, transistors of the array 200 that are coupled to a single BL may be provided based on the channel materials 404 deposited on sidewalls of different openings 424, but where channel regions of different ones of these transistors may be substantially in the same layer with respect to the support structure 402. Thus, FIG. 4 illustrates that, in some embodiments, transistors of the array 200 that are coupled to a single BL may be arranged side-by-side with one another. For example, FIG. 4 illustrates that the transistors T_{1,1,1} and T_{1,4,2}, coupled to a shared BL1, may have their channel regions in a layer 434-1 above and parallel to the support structure 402. Similarly, FIG. 4 illustrates that the transistors T_{2,2,1} and T_{2,5,2}, coupled to a shared BL2, may have their channel regions in a layer 434-2 above and parallel to the support structure 402, while the transistors T_{3,3,1} and T_{3,6,2}, coupled to a shared BL3, may have their channel regions in a layer 434-3 above and parallel to the support structure 402.

FIG. 4 further illustrates gate contacts 428 and contacts 430. The gate contacts 428 may be in electric contact with the gate electrode material 408 in the openings 424 and may be used to apply signals to the gates. The contacts 430 may also be in electric contact with the gate electrode material 408 in the openings 424 and may be used to connect the WLs to row driver transistors (not shown).

FIG. 5 illustrates an IC device 500 that is one example illustration of implementing the array 300 of FIG. 3. As shown in FIG. 5, the IC device 500 includes a support structure 502 and an insulator material 522 over the support structure 502. The support structure 502 may be an example of the support structure 102, described above. The insulator material 522 may include any suitable insulator materials described above, e.g., any suitable ILD material as described above. Furthermore, the IC device 500 includes a plurality of nanoribbons 524, each comprising a channel material 504, shown as nanoribbons 524-1, 524-2, and 524-3, extending through the insulator material 522, substantially parallel to the support structure 502, with their longitudinal axes being along the y-axis of the example coordinate system shown (similar to the nanoribbon 104 of FIG. 1). Each of the nanoribbons 524 is an example of the nanoribbon 104, described above, and the nanoribbons 524-1, 524-2, and 524-3 may be vertically stacked above one another above the support structure 502. Material composition and dimensions of the channel material 504 may be as described above with reference to the nanoribbon 104 of the transistor 110.

Similar to the transistor 110, FIG. 5 illustrates how a gate insulator material 512 and a gate electrode material 508 of different transistors of the floating body memory cells may wrap around portions of the nanoribbons 524. The gate material 512 and the gate electrode material 508 may be analogous to the gate material 112 and the gate electrode material 108 as described above with reference to the transistor 110. Although FIG. 5 illustrates the same channel material 504, gate electrode material 508, and gate insulator material 512 associated with different nanoribbons 524, in various embodiments, material compositions of the channel materials 504 of different nanoribbons 524 may, but do not have to be, the same, material compositions of any one or more of the channel material 504, gate electrode material 508, and gate insulator material 512 associated with different nanoribbons 524 may, but do not have to be, the same.

FIG. 5 further illustrates S/D contacts 526 coupled to S/D regions in the nanoribbons 524. The S/D contacts 526 may be similar to the S/D interface material 426, described above. FIG. 5 further illustrates vias 528 between the S/D contacts 526 and respective BLs or SLs to which the S/D contacts 526 are coupled to. The vias 528 is one example of electrical interconnects that may be used to connect the S/D contacts 526 to respective BLs or SLs. In other embodiments of the IC device 500, the S/D contacts 526 and/or the vias 528 may be absent, or interconnects of other types and geometry may be provided to ensure electrical connectivity between the S/D regions of various transistors provided based on the nanoribbons 524 and respective BLs and SLs.

The IC device 500 of FIG. 5 is an example of the array 300 of FIG. 3 and, therefore, individual transistors T and control lines (i.e., BLs, SLs, and WLs) are labeled in FIG. 5 using the same notation as that used in FIG. 3 and descriptions provided with respect to FIG. 3 are applicable to FIG. 5 and, in the interests of brevity, are not repeated. The IC device 500 includes 2D sub-arrays of floating body memory cells arranged in different layers 534, which layers are analogous to the layer 334 of the array 300. FIG. 5 illustrates different rectangles to highlight approximate boundaries of different transistors. In the IC device 500, the electrically conductive materials used as the gate electrode materials 508 around the nanoribbons 524 provide respective WLs. Only WL1-WL4 of the first layer 534-1 are individually labeled in FIG. 5 and the WLs of the other layers 534 are not labeled in order to not clutter the drawing, but the individual designations of the other WLs are clear from the indices of the individual transistors labeled in FIG. 5. For example, WL1 is formed by the gate electrode material 508 around a first portion of the nanoribbon 524-1, WL2 is formed by the gate electrode material 508 around a second portion of the nanoribbon 524-1, WL3 is formed by the gate electrode material 508 around a third portion of the nanoribbon 524-1, and WL4 is formed by the gate electrode material 508 around a fourth portion of the nanoribbon 524-1.

As shown in FIG. 5, in the IC device 500, the WLs extend in a direction substantially parallel to the support structure 502, e.g., in a direction parallel to the x-axis of the example coordinate system shown. The BLs and the SLs also extend in a direction substantially parallel to the support structure 502, but both BLs and SLs being substantially perpendicular to the WLs (thus, BLs and SLs are parallel to one another and extend in a direction parallel to the y-axis of the example coordinate system shown). Each of the transistors of various floating body memory cells of the IC device 500 are horizontal transistors, because the gate length (i.e., a distance between the first and second S/D regions of a transistor) is measured in the horizontal direction (i.e., in a direction substantially parallel to the support structure 502).

FIG. 5 further illustrates how S/D regions of some of the adjacent transistors may be shared to couple them to the respective control line, as was described with reference to the array 300. For example, in the first layer 534-1, FIG. 5 illustrates a single S/D contact 526 shared by the transistors T_{1,1,1} and T_{1,1,2} to couple the first S/D regions of these transistors to the shared BL1, and further illustrates a single S/D contact 526 shared by the transistors T_{1,1,3} and T_{1,1,4} to couple the first S/D regions of these transistors to the shared BL1. Analogous applies to other layers 534. In some embodiments, the IC device 500 may include a plug 530 in the nanoribbons 524 to electrically disconnect the S/D regions of transistors that do not share any of their S/D regions with one another. For example, a plug 530 may be included in the nanoribbon 524-1 between the closest S/D regions of the transistors T_{1,1,2} and T_{1,1,3}. Similarly, a plug 530 may be included in the nanoribbon 524-2 between the closest S/D regions of the transistors T_{2,2,6} and T_{2,2,7} and/or a plug 530 may be included in the nanoribbon 524-3 between the closest S/D regions of the transistors T_{3,3,10} and T_{3,3,11}. The plug 530 may include any suitable insulator material, e.g., any of the insulator materials described above.

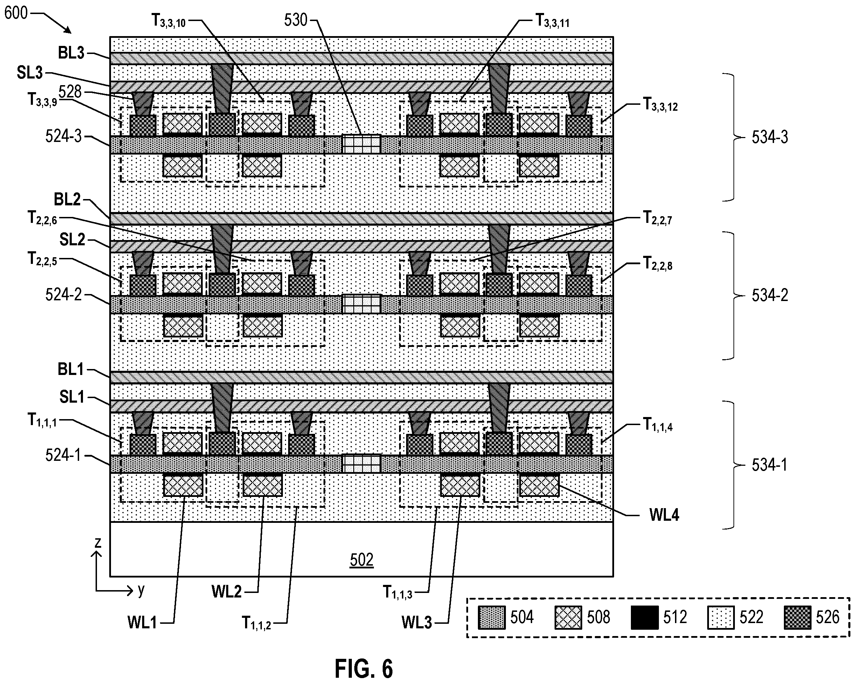

FIG. 5 illustrates an embodiment where, in each layer 534, one of the BL and the SL is below the channel material 504 of the layer 534 and the other one is above the channel material. This means that a contact to the S/D region that is coupled to one of the BL and the SL is made from the top of the transistors T (i.e., from the side of the channel material 504 that is farthest away from the support structure 502), while a contact to the S/D region that is coupled to the other one of the BL and the SL is made from the bottom of the transistors T (i.e., from the side of the channel material 504 that is closest to the support structure 502). For example, in some embodiment, BLs may be below the channel material 504 in each layer 534, while SLs may be above the channel material 504 in each layer 534, as is shown in FIG. 5. In other embodiments, both the BL and the SL for a given layer 534 may be arranged either above the channel material 504 of that layer or below the channel material 504 of that layer. An example where BLs and SLs are arranged above the channel material 504 of individual layers 534 is shown in FIG. 6, illustrating an IC device 600 that is substantially the same as the IC device 500 except for this difference. Other descriptions provided with respect to the IC device 500 are applicable to the IC device 600 and, therefore, in the interest of brevity, are not repeated. The embodiment shown in FIG. 5 may be advantageous in terms of easier routing of BLs and SLs, while the embodiment shown in FIG. 6 may be advantageous in terms of easier manufacturing.

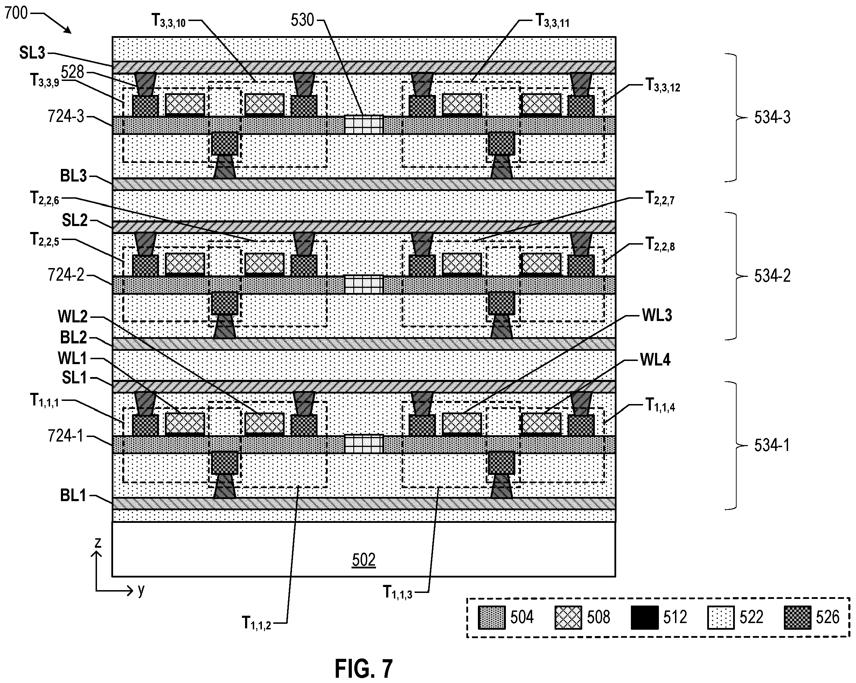

While FIGS. 5-6 illustrate embodiments where, in each layer 534, the channel material 504 is included in a nanoribbon 524, this may be different in other embodiments. For example, FIGS. 7-8 illustrate IC devices similar to those shown in FIGS. 5-6, respectively, but where the channel material 504 is not shaped as a nanoribbon 524, but instead is provided as a layer 724 of the channel material 504, e.g., using layer transfer. In such embodiments, the gate electrode material 508 may not wrap around the channel material 504 but be provided on one side of the channel material 504. One example of this is shown in FIG. 7, illustrating an IC device 700 that is substantially the same as the IC device 500 except that the channel material 504 in each layer 534 is provided as a layer 724 of the channel material 504. FIG. 7 illustrates that the first layer 534-1 includes a layer 724-1 of the channel material 504, the second layer 534-2 includes a layer 724-2 of the channel material 504, and the third layer 534-3 includes a layer 724-3 of the channel material 504. Another difference is that, in the IC device 700, the gate electrode material 508 is provided on the top side of the channel material 504 of each layer 724. Other descriptions provided with respect to the IC device 500 are applicable to the IC device 700 and, therefore, in the interest of brevity, are not repeated.

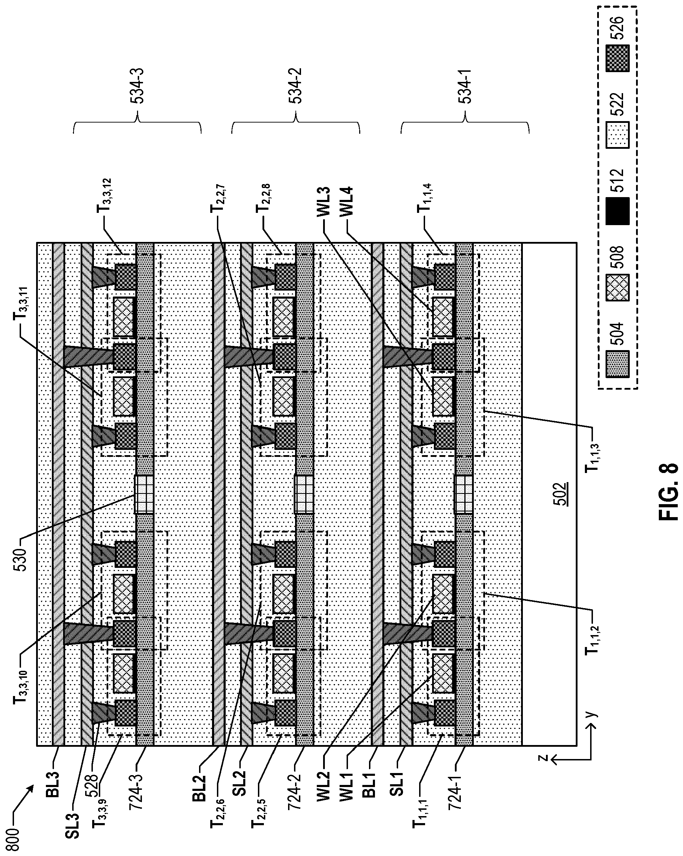

Similar to FIG. 5, FIG. 7 illustrates an embodiment where, in each layer 534, one of the BL and the SL is below the channel material 504 of the layer 534 and the other one is above the channel material. In other embodiments, both the BL and the SL for a given layer 534 may be arranged either above the channel material 504 of that layer or below the channel material 504 of that layer. An example where BLs and SLs are arranged above the channel material 504 of individual layers 534 is shown in FIG. 8, illustrating an IC device 800 that is substantially the same as the IC device 700 except for this difference. Other descriptions provided with respect to the IC device 700 are applicable to the IC device 800 and, therefore, in the interest of brevity, are not repeated. The embodiment shown in FIG. 7 may be advantageous in terms of easier routing of BLs and SLs, while the embodiment shown in FIG. 8 may be advantageous in terms of easier manufacturing.

Various arrangements of the IC devices as illustrated in FIGS. 1-8 do not represent an exhaustive set of IC devices that may implement 3D floating body memory as described herein, but merely provide examples of such devices/structures/assemblies. For example, while FIGS. 5 and 7 illustrate an SL being above the channel material 504 and a BL being below the channel material 504 in each of the layers 534, in other embodiments, this may be reversed for one or more layers 534 (i.e., a BL may be above the channel material 504 and an SL may be below the channel material 504 for one or more layers 534). Similarly, while FIGS. 6 and 8 illustrate both an SL and a BL being above the channel material 504 in each of the layers 534, in other embodiments, this may be reversed for one or more layers 534 (i.e., both an SL and a BL may be below the channel material 504 for one or more layers 534). In another example, while FIGS. 6 and 8 illustrate a BL being further away from the channel material 504 than an SL in each of the layers 534, in other embodiments, this may be reversed for one or more layers 534 (i.e., an SL may be further away from the channel material 504 than a BL for one or more layers 534). In yet another example, while FIGS. 7 and 8 illustrate top-gated transistors T (i.e., for each transistor, the gate electrode material 508 is provided further away from the support structure 502 than the corresponding channel material 504), in other embodiments, at least some of the transistors may be bottom-gated transistors (i.e., for one or more layers 534 or for one or more transistors within a given layer 534, the gate electrode material 508 may be provided closer to the support structure 502 than the corresponding channel material 504). The number and positions of various elements shown in FIGS. 1-8 is purely illustrative and, in various other embodiments, other numbers of these elements, provided in other locations relative to one another may be used in accordance with the general architecture considerations described herein.

Arrangements with one or more IC devices implementing 3D floating body memory as disclosed herein may be included in any suitable electronic device. FIGS. 9-13 illustrate various examples of devices and components that may include one or more IC devices implementing 3D floating body memory as disclosed herein, e.g., any of the IC devices 400, 500, 600, 700, or 800, or any combination of such IC devices, and/or any of the IC devices implementing the arrays 200 or 300 as disclosed herein.

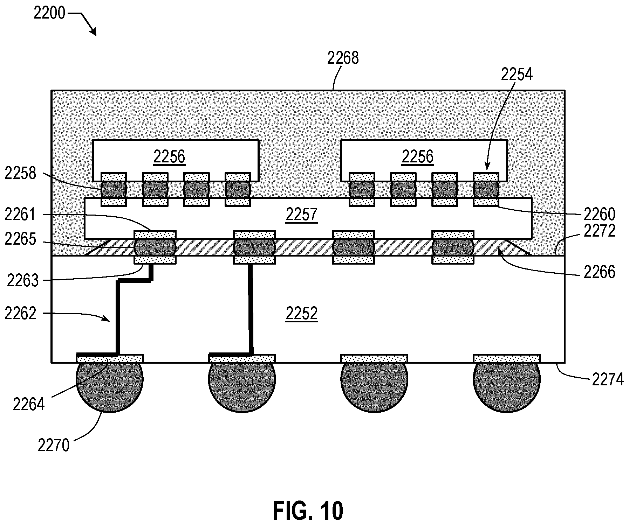

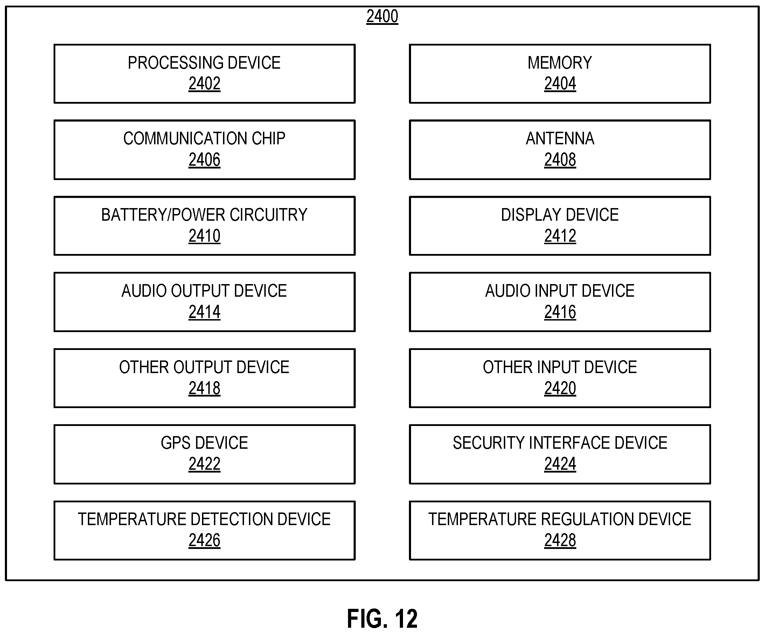

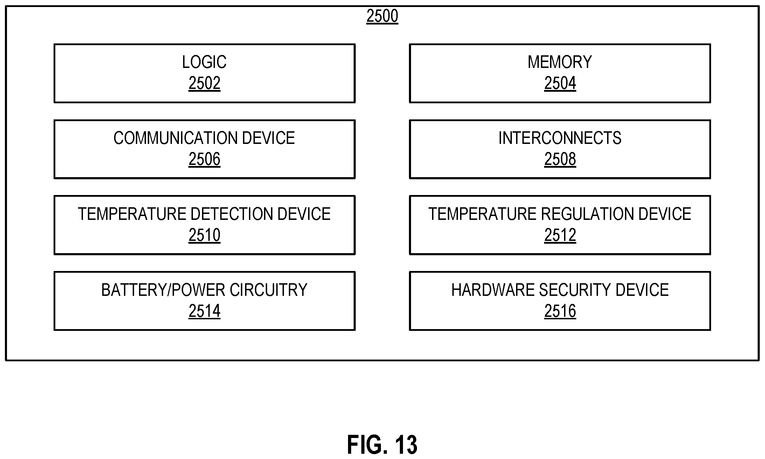

FIG. 9 illustrates top views of a wafer 2000 and dies 2002 that may include one or more IC devices implementing 3D floating body memory in accordance with any of the embodiments disclosed herein. In some embodiments, the dies 2002 may be included in an IC package, in accordance with any of the embodiments disclosed herein. For example, any of the dies 2002 may serve as any of the dies 2256 in an IC package 2200 shown in FIG. 10. The wafer 2000 may be composed of semiconductor material and may include one or more dies 2002 having IC structures formed on a surface of the wafer 2000. Each of the dies 2002 may be a repeating unit of a semiconductor product that includes any suitable IC (e.g., ICs including one or more IC devices implementing 3D floating body memory as described herein, e.g., ICs including any of the IC devices 400, 500, 600, 700, or 800, or any combination of such IC devices, and/or any of the IC devices implementing the arrays 200 or 300 as disclosed herein). After the fabrication of the semiconductor product is complete (e.g., after manufacture of any embodiment of the IC devices 400, 500, 600, 700, or 800, or any combination of such IC devices, and/or any of the IC devices implementing the arrays 200 or 300 as disclosed herein), the wafer 2000 may undergo a singulation process in which each of the dies 2002 is separated from one another to provide discrete "chips" of the semiconductor product. In particular, devices that include one or more IC devices implementing 3D floating body memory as disclosed herein may take the form of the wafer 2000 (e.g., not singulated) or the form of the die 2002 (e.g., singulated). The die 2002 may include supporting circuitry to route electrical signals to various memory cells, transistors, capacitors, as well as any other IC components. In some embodiments, the wafer 2000 or the die 2002 may implement or include a memory device (e.g., a 3D floating body memory as described herein), a logic device (e.g., an AND, OR, NAND, or NOR gate), or any other suitable circuit element. Multiple ones of these devices may be combined on a single die 2002. For example, a memory array formed by multiple memory devices may be formed on a same die 2002 as a processing device (e.g., the processing device 2402 of FIG. 12 or the logic 2502 of FIG. 13) or other logic that is configured to store information in the memory devices or execute instructions stored in the memory array.

FIG. 10 is a side, cross-sectional view of an example IC package 2200 that may include one or more IC devices implementing 3D floating body memory in accordance with any of the embodiments disclosed herein. In some embodiments, the IC package 2200 may be a system-in-package (SiP).

The package substrate 2252 may be formed of a dielectric material (e.g., a ceramic, a buildup film, an epoxy film having filler particles therein, etc.), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 10 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 10 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

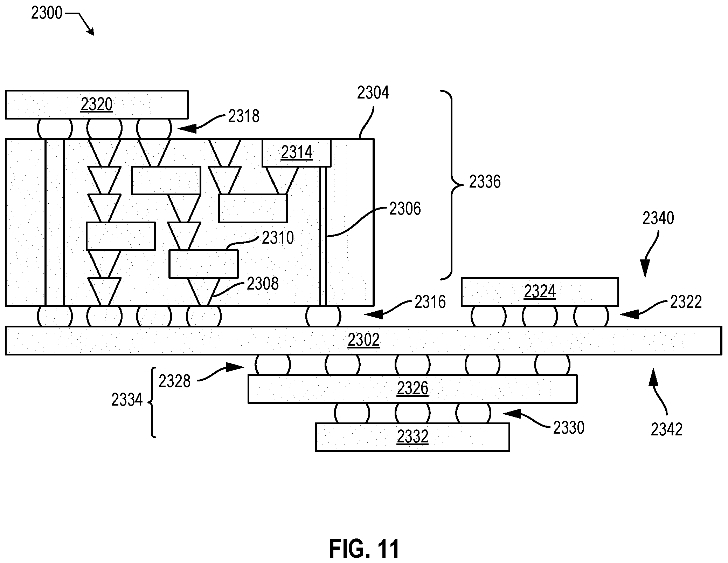

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 10 are solder balls (e.g., for a ball grid array arrangement), but any suitable second-level interconnects 22770 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 11.

The dies 2256 may take the form of any of the embodiments of the die 2002 discussed herein (e.g., may include any of the embodiments of the IC devices implementing 3D floating body memory as described herein, e.g., any of the IC devices 400, 500, 600, 700, or 800, or any combination of such IC devices, and/or any of the IC devices implementing the arrays 200 or 300 as disclosed herein). In embodiments in which the IC package 2200 includes multiple dies 2256, the IC package 2200 may be referred to as a multi-chip package (MCP). The dies 2256 may include circuitry to perform any desired functionality. For example, one or more of the dies 2256 may be logic dies (e.g., silicon-based dies), and one or more of the dies 2256 may be memory dies (e.g., high bandwidth memory), including embedded memory dies as described herein. In some embodiments, any of the dies 2256 may include one or more IC devices implementing 3D floating body memory, e.g., as discussed above; in some embodiments, at least some of the dies 2256 may not include any IC devices implementing 3D floating body memory.

The IC package 2200 illustrated in FIG. 10 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 10, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 11 is a cross-sectional side view of an IC device assembly 2300 that may include components having one or more IC devices implementing 3D floating body memory in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of one or more IC devices implementing 3D floating body memory in accordance with any of the embodiments disclosed herein; e.g., any of the IC packages discussed below with reference to the IC device assembly 2300 may take the form of any of the embodiments of the IC package 2200 discussed above with reference to FIG. 10 (e.g., may include one or more IC devices implementing 3D floating body memory provided on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 11 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 11), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 9), an IC device, or any other suitable component. In particular, the IC package 2320 may include one or more IC devices implementing 3D floating body memory as described herein. Although a single IC package 2320 is shown in FIG. 11, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 11, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) protection devices, and memory devices. More complex devices such as radio frequency (RF) devices, power amplifiers, power management devices, antennas, arrays, sensors, and microelectromechanical systems (MEMS) devices may also be formed on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 11 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

FIG. 12 is a block diagram of an example computing device 2400 that may include one or more components including 3D floating body memory in accordance with any of the embodiments disclosed herein. For example, any suitable ones of the components of the computing device 2400 may include a die (e.g., the die 2002 of FIG. 9) having one or more IC devices implementing 3D floating body memory as described herein. Any one or more of the components of the computing device 2400 may include, or be included in, an IC package 2200 of FIG. 10 or an IC device 2300 of FIG. 11.

A number of components are illustrated in FIG. 12 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC die.

Additionally, in various embodiments, the computing device 2400 may not include one or more of the components illustrated in FIG. 12, but the computing device 2400 may include interface circuitry for coupling to the one or more components. For example, the computing device 2400 may not include a display device 2412, but may include display device interface circuitry (e.g., a connector and driver circuitry) to which a display device 2412 may be coupled. In another set of examples, the computing device 2400 may not include an audio input device 2416 or an audio output device 2414, but may include audio input or output device interface circuitry (e.g., connectors and supporting circuitry) to which an audio input device 2416 or audio output device 2414 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid state memory, and/or a hard drive. In some embodiments, the memory 2404 may include memory that shares a die with the processing device 2402. This memory may be used as cache memory and may include embedded DRAM (eDRAM) or spin transfer torque magnetic RAM (MRAM). In some embodiments, the memory 2404 may include one or more IC devices implementing 3D floating body memory as described herein, e.g., any of the IC devices 400, 500, 600, 700, or 800, or any combination of such IC devices, and/or any of the IC devices implementing the arrays 200 or 300 as disclosed herein.

In some embodiments, the computing device 2400 may include a communication chip 2406 (e.g., one or more communication chips). For example, the communication chip 2406 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2406 may implement any of a number of wireless standards or protocols, including but not limited to Institute for Electrical and Electronic Engineers (IEEE) standards including Wi-Fi (IEEE 1402.11 family), IEEE 1402.16 standards (e.g., IEEE 1402.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.16 standards. The communication chip 2406 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2406 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2406 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2406 may operate in accordance with other wireless protocols in other embodiments. The computing device 2400 may include an antenna 2408 to facilitate wireless communications and/or to receive other wireless communications (such as AM or FM radio transmissions).

In some embodiments, the communication chip 2406 may manage wired communications, such as electrical, optical, or any other suitable communication protocols (e.g., the Ethernet). As noted above, the communication chip 2406 may include multiple communication chips. For instance, a first communication chip 2406 may be dedicated to shorter-range wireless communications such as Wi-Fi or Bluetooth, and a second communication chip 2406 may be dedicated to longer-range wireless communications such as global positioning system (GPS), EDGE, GPRS, CDMA, WiMAX, LTE, EV-DO, or others. In some embodiments, a first communication chip 2406 may be dedicated to wireless communications, and a second communication chip 2406 may be dedicated to wired communications.

The computing device 2400 may include a battery/power circuitry 2410. The battery/power circuitry 2410 may include one or more energy storage devices (e.g., batteries or capacitors) and/or circuitry for coupling components of the computing device 2400 to an energy source separate from the computing device 2400 (e.g., AC line power).

The computing device 2400 may include a display device 2412 (or corresponding interface circuitry, as discussed above). The display device 2412 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2414 (or corresponding interface circuitry, as discussed above). The audio output device 2414 may include any device that generates an audible indicator, such as speakers, headsets, or earbuds, for example.

The computing device 2400 may include an audio input device 2416 (or corresponding interface circuitry, as discussed above). The audio input device 2416 may include any device that generates a signal representative of a sound, such as microphones, microphone arrays, or digital instruments (e.g., instruments having a musical instrument digital interface (MIDI) output).

The computing device 2400 may include an other output device 2418 (or corresponding interface circuitry, as discussed above). Examples of the other output device 2418 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may include a GPS device 2422 (or corresponding interface circuitry, as discussed above). The GPS device 2422 may be in communication with a satellite-based system and may receive a location of the computing device 2400, as known in the art.

The computing device 2400 may include a security interface device 2424. The security interface device 2424 may include any device that provides security features for the computing device 2400 or for any individual components therein (e.g., for the processing device 2402 or for the memory 2404). Examples of security features may include authorization, access to digital certificates, access to items in keychains, etc. Examples of the security interface device 2424 may include a software firewall, a hardware firewall, an antivirus, a content filtering device, or an intrusion detection device.

In some embodiments, the computing device 2400 may include a temperature detection device 2426 and a temperature regulation device 2428.

The temperature detection device 2426 may include any device capable of determining temperatures of the computing device 2400 or of any individual components therein (e.g., temperatures of the processing device 2402 or of the memory 2404). In various embodiments, the temperature detection device 2426 may be configured to determine temperatures of an object (e.g., the computing device 2400, components of the computing device 2400, devices coupled to the computing device, etc.), temperatures of an environment (e.g., a data center that includes, is controlled by, or otherwise associated with the computing device 2400), and so on. The temperature detection device 2426 may include one or more temperature sensors. Different temperature sensors of the temperature detection device 2426 may have different locations within and around the computing device 2400. A temperature sensor may generate data (e.g., digital data) representing detected temperatures and provide the data to another device, e.g., to the temperature regulation device 2428, the processing device 2402, the memory 2404, etc. In some embodiments, a temperature sensor of the temperature detection device 2426 may be turned on or off, e.g., by the processing device 2402 or an external system. The temperature sensor detects temperatures when it is on and does not detect temperatures when it is off. In other embodiments, a temperature sensor of the temperature detection device 2426 may detect temperatures continuously and automatically or detect temperatures at predefined times or at times triggered by an event associated with the computing device 2400 or any components therein.

The temperature regulation device 2428 may include any device configured to change (e.g., decrease) temperatures, e.g., based on one or more target temperatures and/or based on temperature measurements performed by the temperature detection device 2426. A target temperature may be a preferred temperature. A target temperature may depend on a setting in which the computing device 2400 operates. In some embodiments, the target temperature may be 200 Kelvin degrees or lower. In some embodiments, the target temperature may be 20 Kelvin degrees or lower, or 5 Kelvin degrees or lower. Target temperatures for different objects and different environments of, or associated with, the computing device 2400 can be different. In some embodiments, cooling provided by the temperature regulation device 2428 may be a multi-stage process with temperatures ranging from room temperature to 4K or lower.

In some embodiments, the temperature regulation device 2428 may include one or more cooling devices. Different cooling device may have different locations within and around the computing device 2400. A cooling device of the temperature regulation device 2428 may be associated with one or more temperature sensors of the temperature detection device 2426 and may be configured to operate based on temperatures detected the temperature sensors. For instance, a cooling device may be configured to determine whether a detected ambient temperature is above the target temperature or whether the detected ambient temperature is higher than the target temperature by a predetermined value or determine whether any other temperature-related condition associated with the temperature of the computing device 2400 is satisfied. In response to determining that one or more temperature-related condition associated with the temperature of the computing device 2400 are satisfied (e.g., in response to determining that the detected ambient temperature is above the target temperature), a cooling device may trigger its cooling mechanism and start to decrease the ambient temperature. Otherwise, the cooling device does not trigger any cooling. A cooling device of the temperature regulation device 2428 may operate with various cooling mechanisms, such as evaporation cooling, radiation cooling, conduction cooling, convection cooling, other cooling mechanisms, or any combination thereof. A cooling device of the temperature regulation device 2428 may include a cooling agent, such as a water, oil, liquid nitrogen, liquid helium, etc. In some embodiments, the temperature regulation device 2428 may be, for example, a dilution refrigerator, a helium-3 refrigerator, or a liquid helium refrigerator. In some embodiments, the temperature regulation device 2428 or any portions thereof (e.g., one or more of the individual cooling devices) may be connected to the computing device 2400 in close proximity (e.g., less than about 1 meter) or may be provided in a separate enclosure where a dedicated heat exchanger (e.g., a compressor, a heating, ventilation, and air conditioning (HVAC) system, liquid helium, liquid nitrogen, etc.) may reside.

By maintaining the target temperatures, the energy consumption of the computing device 2400 (or components thereof) can be reduced, while the computing efficiency may be improved. For example, when the computing device 2400 (or components thereof) operates at lower temperatures, energy dissipation (e.g., heat dissipation) may be reduced. Further, energy consumed by semiconductor components (e.g., energy needed for switching transistors of any of the components of the computing device 2400) can also be reduced. Various semiconductor materials may have lower resistivity and/or higher mobility at lower temperatures. That way, the electrical current per unit supply voltage may be increased by lowering temperatures. Conversely, for the same current that would be needed, the supply voltage may be lowered by lowering temperatures. As energy corelates to the supply voltage, the energy consumption of the semiconductor components may lower too. In some implementations, the energy savings due to reducing heat dissipation and reducing energy consumed by semiconductor components of the computing device or components thereof may outweigh (sometimes significantly outweigh) the costs associated with energy needed for cooling.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

FIG. 13 is a block diagram of an example processing device 2500 that may include one or more components including 3D floating body memory in accordance with any of the embodiments disclosed herein. For example, any suitable ones of the components of the processing device 2500 may include a die (e.g., the die 2002 of FIG. 9) having one or more IC devices implementing 3D floating body memory as described herein. Any one or more of the components of the processing device 2500 may include, or be included in, an IC device 2300 (FIG. 11). Any one or more of the components of the processing device 2500 may include, or be included in, an IC package 2200 of FIG. 10 or an IC device 2300 of FIG. 11. Any one or more of the components of the processing device 2500 may include, or be included in, a computing device 2400 of FIG. 12; for example, the processing device 2500 may be the processing device 2402 of the computing device 2400.

A number of components are illustrated in FIG. 13 as included in the processing device 2500, but any one or more of these components may be omitted or duplicated, as suitable for the application. In some embodiments, some or all of the components included in the processing device 2500 may be attached to one or more motherboards. In some embodiments, some or all of these components are fabricated on a single SoC die or coupled to a single support structure, e.g., to a single carrier substrate.

Additionally, in various embodiments, the processing device 2500 may not include one or more of the components illustrated in FIG. 13, but the processing device 2500 may include interface circuitry for coupling to the one or more components. For example, the processing device 2500 may not include a memory 2504, but may include display device interface circuitry (e.g., a connector and driver circuitry) to which a memory 2504 may be coupled.

The processing device 2500 may include logic circuitry 2502 (e.g., one or more circuits configured to implement logic/compute functionality). Examples of such circuits include ICs implementing one or more of input/output (I/O) functions, arithmetic operations, pipelining of data, etc.

In some embodiments, the logic circuitry 2502 may include one or more circuits responsible for read/write operations with respect to the data stored in the memory 2504. To that end, the logic circuitry 2502 may include one or more I/O ICs configured to control access to data stored in the memory 2504.

In some embodiments, the logic circuitry 2502 may include one or more high-performance compute dies, configured to perform various operations with respect to data stored in the memory 2504 (e.g., arithmetic and logic operations, pipelining of data from one or more memory dies of the memory 2504, and possibly also data from external devices/chips). In some embodiments, the logic circuitry 2502 may be configured to only control I/O access to data but not perform any operations on the data. In some embodiments, the logic circuitry 2502 may implement ICs configured to implement I/O control of data stored in the memory 2504, assemble data from the memory 2504 for transport (e.g., transport over a central bus) to devices/chips that are either internal or external to the processing device 2500, etc. In some embodiments, the logic circuitry 2502 may not be configured to perform any operations on the data besides I/O and assembling for transport to the memory 2504.

The processing device 2500 may include a memory 2504, which may include one or more ICs configure to implement memory circuitry (e.g., ICs implementing one or more of memory devices, memory arrays, control logic configured to control the memory devices and arrays, etc.). In some embodiments, the memory 2504 may be implemented substantially as described above with reference to the memory 2404 (FIG. 12). In some embodiments, the memory 2504 may be a designated device configured to provide storage functionality for the components of the processing device 2500 (e.g., local), while the memory 1604 may be configured to provide system-level storage functionality for the entire computing device 2400 (e.g., global). In some embodiments, the memory 2504 may include memory that shares a die with the logic circuitry 2502. In some embodiments, the memory 2504 may include one or more IC devices implementing 3D floating body memory as described herein, e.g., any of the IC devices 400, 500, 600, 700, or 800, or any combination of such IC devices, and/or any of the IC devices implementing the arrays 200 or 300 as disclosed herein.

In some embodiments, the memory 2504 may include a flat memory (also sometimes referred to as a "flat hierarchy memory" or a "linear memory") and, therefore, may also be referred to as a "basin memory." As known in the art, a flat memory or a linear memory refers to a memory addressing paradigm in which memory may appear to the program as a single contiguous address space, where a processor can directly and linearly address all of the available memory locations without having to resort to memory segmentation or paging schemes. Thus, the memory implemented in the memory 2504 may be a memory that is not divided into hierarchical layer or levels in terms of access of its data.

In some embodiments, the memory 2504 may include a hierarchical memory. In this context, hierarchical memory refers to the concept of computer architecture where computer storage is separated into a hierarchy based on features of memory such as response time, complexity, capacity, performance, and controlling technology. Designing for high performance may require considering the restrictions of the memory hierarchy, e.g., the size and capabilities of each component. With hierarchical memory, each of the various memory components can be viewed as part of a hierarchy of memories (m₁, m₂, ..., mₙ) in which each member mᵢ is typically smaller and faster than the next highest member mᵢ₊₁ of the hierarchy. To limit waiting by higher levels, a lower level of a hierarchical memory structure may respond by filling a buffer and then signaling for activating the transfer. For example, in some embodiments, the hierarchical memory implemented in the memory 2504 may be separated into four major storage levels: 1) internal storage (e.g., processor registers and cache), 2) main memory (e.g., the system RAM and controller cards), and 3) on-line mass storage (e.g., secondary storage), and 4) off-line bulk storage (e.g., tertiary, and off-line storage). However, as the number of levels in the memory hierarchy and the performance at each level has increased over time and is likely to continue to increase in the future, this example hierarchical division provides only one non-limiting example of how the memory 2504 may be arranged.

The processing device 2500 may include a communication device 2506, which may be implemented substantially as described above with reference to the communication chip 2406 (FIG. 12). In some embodiments, the communication device 2506 may be a designated device configured to provide communication functionality for the components of the processing device 2500 (e.g., local), while the communication chip 2406 may be configured to provide system-level communication functionality for the entire computing device 2400 (e.g., global).

The processing device 2500 may include interconnects 2508, which may include any element or device that includes an electrically conductive material for providing electrical connectivity to one or more components of, or associated with, a processing device 2500 or/and between various such components. Examples of the interconnects 2508 include conductive lines/wires (also sometimes referred to as "lines" or "metal lines" or "trenches") and conductive vias (also sometimes referred to as "vias" or "metal vias"), metallization stacks, redistribution layers, MIM structures, etc.

The processing device 2500 may include a temperature detection device 2510 which may be implemented substantially as described above with reference to the temperature detection device 2426 of FIG. 12 but configured to determine temperatures on a more local scale, e.g., of the processing device 2500 of components thereof. In some embodiments, the temperature detection device 2510 may be a designated device configured to provide temperature detection functionality for the components of the processing device 2500 (e.g., local), while the temperature detection device 2426 may be configured to provide system-level temperature detection functionality for the entire computing device 2400 (e.g., global).

The processing device 2500 may include a temperature regulation device 2512 which may be implemented substantially as described above with reference to the temperature regulation device 2428 of FIG. 12 but configured to regulate temperatures on a more local scale, e.g., of the processing device 2500 of components thereof. In some embodiments, the temperature regulation device 2512 may be a designated device configured to provide temperature regulation functionality for the components of the processing device 2500 (e.g., local), while the temperature regulation device 2428 may be configured to provide system-level temperature regulation functionality for the entire computing device 2400 (e.g., global).

The processing device 2500 may include a battery/power circuitry 2514 which may be implemented substantially as described above with reference to the battery/power circuitry 2410 of FIG. 12. In some embodiments, the battery/power circuitry 2514 may be a designated device configured to provide battery/power functionality for the components of the processing device 2500 (e.g., local), while the battery/power circuitry 2410 may be configured to provide system-level battery/power functionality for the entire computing device 2400 (e.g., global).

The processing device 2500 may include a hardware security device 2516 which may be implemented substantially as described above with reference to the security interface device 2424 of FIG. 12. In some embodiments, the hardware security device 2516 may be a physical computing device configured to safeguard and manage digital keys, perform encryption and decryption functions for digital signatures, authentication, and other cryptographic functions. In some embodiments, the hardware security device 2516 may include one or more secure crypto processors chips.

The following paragraphs provide various examples of the embodiments disclosed herein.

Example 1 provides an IC device that includes a support structure (e.g., a substrate, a wafer, a die, or a chip) and a floating body memory cell over the support structure, the floating body memory cell including a transistor having a first region, a second region, and a gate over a channel portion between the first region and the second region, where one of the first region and the second region is a source region and another one of the first region and the second region is a drain region. The IC device further includes a bitline coupled (e.g., directly connected ) to the first region and parallel to a first axis of a Cartesian coordinate system; a selectline coupled (e.g., directly connected ) to the second region and parallel to a second axis of the coordinate system; and a wordline coupled (e.g., directly connected ) to or being a part of the gate and parallel to a third axis of the coordinate system.

Example 2 provides the IC device according to example 1, where the floating body memory cell is a first floating body memory cell of a plurality of floating body memory cells, the IC device further includes a second floating body memory cell, the wordline is further coupled (e.g., directly connected ) to or is a part of a gate of a transistor of the second floating body memory cell, and the transistor of the second floating body memory cell is stacked above the transistor of the first floating body memory cell.

Example 3 provides the IC device according to example 2, further including an insulator material over the support structure; an opening extending through the insulator material towards the support structure; and a channel material in sidewalls of the opening, where a channel region of the transistor of the first floating body memory cell is a first portion of the channel material, and a channel region of the transistor of the second floating body memory cell is a second portion of the channel material.

Example 4 provides the IC device according to example 3, where the second portion and the first portion are materially continuous portions of the channel material.

Example 5 provides the IC device according to examples 3 or 4, where the opening is a via substantially perpendicular to the support structure.

Example 6 provides the IC device according to any one of examples 3-5, further including an electrically conductive material in the opening, where the electrically conductive material in the opening is a part of the wordline.

Example 7 provides the IC device according to example 6, further including a gate dielectric in the opening, where the gate dielectric is between the electrically conductive material in the opening and the channel material.

Example 8 provides the IC device according to examples 6 or 7, where the opening is a first opening, the electrically conductive material is a first electrically conductive material, the wordline is a first wordline, and the IC device further includes a second wordline, a third floating body memory cell, and a second opening extending through the insulator material towards the support structure a including a second electrically conductive material in the second opening, where the bitline is further coupled (e.g., directly connected ) to a source region or a drain region of a transistor of the third floating body memory cell, the second electrically conductive material in the second opening is a part of the second wordline, and the second wordline is coupled (e.g., directly connected ) to or is a part of a gate of the transistor of the third floating body memory cell.

Example 9 provides an IC device that includes an insulator material over a support structure (e.g., a substrate, a wafer, a die, or a chip); a first opening extending through the insulator material towards the support structure and having a first channel material on sidewalls of the first opening; a second opening extending through the insulator material towards the support structure and having a second channel material on sidewalls of the second opening; a first transistor having a channel region in a first portion of the first channel material; a second transistor having a channel region in a second portion of the first channel material, the second portion being further away from the support structure than the first portion; and a third transistor having a channel region in a portion of the second channel material, where a first source or drain (S/D) region of the first transistor is coupled (e.g., directly connected ) to a first control line, a first S/D region of the second transistor is coupled (e.g., directly connected ) to a second control line, a first S/D region of the third transistor is coupled (e.g., directly connected ) to a third control line, and a second S/D region of the first transistor, a second S/D region of the second transistor and a second S/D region of the third transistor are coupled (e.g., directly connected ) to a fourth control line.

Example 10 provides the IC device according to example 9, where the first opening is at least partially filled with a first conductive material, the second opening is at least partially filled with a second conductive material, the first conductive material is a part of a gate stack of the first transistor and a part of a gate stack of the second transistor, and the second conductive material is a part of a gate stack of the third transistor.

Example 11 provides the IC device according to example 10, where the first conductive material in the first opening is a fifth control line, and the second conductive material in the second opening is a sixth control line.

Example 12 provides the IC device according to example 11, where the fifth control line and the sixth control line are substantially perpendicular to the support structure.

Example 13 provides the IC device according to any one of examples 9-12, where the first control line, the second control line, and the third control line are substantially parallel to one another and substantially parallel to the support structure.

Example 14 provides the IC device according to example 14, where the fourth control line is substantially perpendicular to the first control line and substantially parallel to the support structure.

Example 15 provides the IC device according to any one of examples 9-14, where the first control line and the fourth control line are substantially perpendicular to the first opening and substantially perpendicular to one another.

Example 16 provides the IC device according to any one of examples 9-15, where the first transistor is a first floating body memory cell, the second transistor is a second floating body memory cell, and the third transistor is a third floating body memory cell.

Example 17 provides an IC device that includes a support structure (e.g., a substrate, a wafer, a die, or a chip); a semiconductor material in a layer substantially parallel to the support structure; first, second, third, and fourth transistors having channel regions in different portions of the semiconductor material; first, second, third, and fourth control lines (e.g., respective WLs) coupled (e.g., directly connected ) to, respectively, gates of the first, second, third, and fourth transistors; a fifth control line (e.g., a shared BL) coupled (e.g., directly connected ) to a first region of each of the first, second, third, and fourth transistors; and a sixth control line (e.g., a shared SL) coupled (e.g., directly connected ) to a second region of each of the first, second, third, and fourth transistors, where one of the first region and the second region is a source region and another one of the first region and the second region is a drain region.

Example 18 provides the IC device according to example 17, where the first, second, third, and fourth control lines are substantially parallel to one another and to the support structure.

Example 19 provides the IC device according to examples 17 or 18, where the fifth and sixth control lines are substantially parallel to one another and to the support structure, and are substantially perpendicular to the first control line.

Example 20 provides the IC device according to any one of examples 17-19, where the fifth control line is closer to the support structure than the semiconductor material, and the semiconductor material is closer to the support structure than the sixth control line.

Example 21 provides an IC package that includes an IC die, including an IC device; and a further component, coupled to the IC die, where the IC device is an IC device according to any one of the preceding examples.

Example 22 provides the IC package according to example 21, where the further component is one of a package substrate, an interposer, or a further IC die.

Example 23 provides an electronic device that includes a carrier substrate; and one or more of the IC devices according to any one of the preceding examples and/or the IC package according to any one of the preceding examples, coupled to the carrier substrate.

Example 24 provides the electronic device according to example 23, where the carrier substrate is a motherboard.

Example 25 provides the electronic device according to example 23, where the carrier substrate is a PCB.

Example 26 provides the electronic device according to any one of examples 23-25, where the electronic device is a wearable electronic device (e.g., a smart watch) or handheld electronic device (e.g., a mobile phone).

Example 27 provides the electronic device according to any one of examples 23-26, where the electronic device further includes one or more communication chips and an antenna.

Example 28 provides the electronic device according to any one of examples 23-27, where the electronic device is memory device.

Example 29 provides the electronic device according to any one of examples 23-27, where the electronic device is one of an RF transceiver, a switch, a power amplifier, a low-noise amplifier, a filter, a filter bank, a duplexer, an upconverter, or a downconverter of an RF communications device, e.g., of an RF transceiver.

Example 30 provides the electronic device according to any one of examples 23-27, where the electronic device is a computing device.

Example 31 provides the electronic device according to any one of examples 23-30, where the electronic device is included in a base station of a wireless communication system.

Example 32 provides the electronic device according to any one of examples 23-30, where the electronic device is included in a user equipment device (i.e., a mobile device) of a wireless communication system.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

The following section of the description relates to further examples. The numbered paragraphs in this section are not claims. The claims are set forth below in the later section headed "Claims".

### Clauses

Clause 1. An integrated circuit (IC) device, comprising:
a floating body memory cell comprising a transistor having a first region, a second region, and a gate over a channel portion between the first region and the second region, wherein one of the first region and the second region is a source region and another one of the first region and the second region is a drain region;
a bitline coupled to the first region and parallel to a first axis of a coordinate system;
a selectline coupled to the second region and parallel to a second axis of the coordinate system; and
a wordline coupled to or being a part of the gate and parallel to a third axis of the coordinate system.

Clause 2. The IC device according to clause 1, wherein the floating body memory cell is a first floating body memory cell of a plurality of floating body memory cells, the IC device further includes a second floating body memory cell, the wordline is further coupled to or is a part of a gate of a transistor of the second floating body memory cell, and the transistor of the second floating body memory cell is stacked above the transistor of the first floating body memory cell.

Clause 3. The IC device according to clause 2, further comprising:
a support structure;
an insulator material over the support structure;
an opening extending through the insulator material towards the support structure; and
a channel material in sidewalls of the opening,
wherein a channel region of the transistor of the first floating body memory cell is a first portion of the channel material, and a channel region of the transistor of the second floating body memory cell is a second portion of the channel material.

Clause 4. The IC device according to clause 3, wherein the second portion and the first portion are materially continuous portions of the channel material.

Clause 5. The IC device according to clause 3, wherein the opening is a via substantially perpendicular to the support structure.

Clause 6. The IC device according to clause 3, further comprising an electrically conductive material in the opening, wherein the electrically conductive material in the opening is a part of the wordline.

Clause 7. The IC device according to clause 6, further comprising a gate dielectric in the opening, wherein the gate dielectric is between the electrically conductive material in the opening and the channel material.

Clause 8. The IC device according to clause 6, wherein the opening is a first opening, the electrically conductive material is a first electrically conductive material, the wordline is a first wordline, and the IC device further includes a second wordline, a third floating body memory cell, and a second opening extending through the insulator material towards the support structure a comprising a second electrically conductive material in the second opening, wherein:
the bitline is further coupled to a source region or a drain region of a transistor of the third floating body memory cell,
the second electrically conductive material in the second opening is a part of the second wordline, and
the second wordline is coupled to or is a part of a gate of the transistor of the third floating body memory cell.

Clause 9. An integrated circuit (IC) device, comprising:
an insulator material over a substrate;
a first opening extending through the insulator material towards the substrate and having a first channel material on sidewalls of the first opening;
a second opening extending through the insulator material towards the substrate and having a second channel material on sidewalls of the second opening;
a first transistor having a channel region in a first portion of the first channel material;
a second transistor having a channel region in a second portion of the first channel material, the second portion being further away from the substrate than the first portion; and
a third transistor having a channel region in a portion of the second channel material,
wherein a first source or drain (S/D) region of the first transistor is coupled to a first control line, a first S/D region of the second transistor is coupled to a second control line, a first S/D region of the third transistor is coupled to a third control line, and a second S/D region of the first transistor, a second S/D region of the second transistor and a second S/D region of the third transistor are coupled to a fourth control line.

Clause 10. The IC device according to clause 9, wherein the first opening is at least partially filled with a first conductive material, the second opening is at least partially filled with a second conductive material, the first conductive material is a part of a gate stack of the first transistor and a part of a gate stack of the second transistor, and the second conductive material is a part of a gate stack of the third transistor.

Clause 11. The IC device according to clause 10, wherein the first conductive material in the first opening is a fifth control line, and the second conductive material in the second opening is a sixth control line.

Clause 12. The IC device according to clause 11, wherein the fifth control line and the sixth control line are substantially perpendicular to the substrate.

Clause 13. The IC device according to clause 9, wherein the first control line, the second control line, and the third control line are substantially parallel to one another and substantially parallel to the substrate.

Clause 14. The IC device according to clause 13, wherein the fourth control line is substantially perpendicular to the first control line and substantially parallel to the substrate.

Clause 15. The IC device according to clause 9, wherein the first control line and the fourth control line are substantially perpendicular to the first opening and substantially perpendicular to one another.

Clause 16. The IC device according to clause 9, wherein the first transistor is a first floating body memory cell, the second transistor is a second floating body memory cell, and the third transistor is a third floating body memory cell.

Clause 17. An integrated circuit (IC) device, comprising:
a die;
a semiconductor material in a layer substantially parallel to the die;
first, second, third, and fourth transistors having channel regions in different portions of the semiconductor material;
first, second, third, and fourth control lines coupled to, respectively, gates of the first, second, third, and fourth transistors;
a fifth control line coupled to a first region of each of the first, second, third, and fourth transistors; and
a sixth control line coupled to a second region of each of the first, second, third, and fourth transistors, wherein one of the first region and the second region is a source region and another one of the first region and the second region is a drain region.

Clause 18. The IC device according to clause 17, wherein the first, second, third, and fourth control lines are substantially parallel to one another and to the die.

Clause 19. The IC device according to clause 17, wherein the fifth and sixth control lines are substantially parallel to one another and to the die and are substantially perpendicular to the first control line.

Clause 20. The IC device according to clause 17, wherein the fifth control line is closer to the die than the semiconductor material, and the semiconductor material is closer to the die than the sixth control line.

## Claims

1. An integrated circuit (IC) device, comprising:
a floating body memory cell comprising a transistor having a first region, a second region, and a gate over a channel portion between the first region and the second region, wherein one of the first region and the second region is a source region and another one of the first region and the second region is a drain region;
a bitline coupled to the first region and parallel to a first axis of a coordinate system;
a selectline coupled to the second region and parallel to a second axis of the coordinate system; and
a wordline coupled to or being a part of the gate and parallel to a third axis of the coordinate system.

2. The IC device according to claim 1, wherein the floating body memory cell is a first floating body memory cell of a plurality of floating body memory cells, the IC device further includes a second floating body memory cell, the wordline is further coupled to or is a part of a gate of a transistor of the second floating body memory cell, and the transistor of the second floating body memory cell is stacked above the transistor of the first floating body memory cell.

3. The IC device according to claim 2, further comprising:
a support structure;
an insulator material over the support structure;
an opening extending through the insulator material towards the support structure; and
a channel material in sidewalls of the opening,
wherein a channel region of the transistor of the first floating body memory cell is a first portion of the channel material, and a channel region of the transistor of the second floating body memory cell is a second portion of the channel material.

4. The IC device according to claim 3, wherein the second portion and the first portion are materially continuous portions of the channel material.

5. The IC device according to any one of claims 3-4, further comprising an electrically conductive material in the opening, wherein the electrically conductive material in the opening is a part of the wordline.

6. The IC device according to claim 5, further comprising a gate dielectric in the opening, wherein the gate dielectric is between the electrically conductive material in the opening and the channel material.

7. The IC device according to claims 5 or 6, wherein the opening is a first opening, the electrically conductive material is a first electrically conductive material, the wordline is a first wordline, and the IC device further includes a second wordline, a third floating body memory cell, and a second opening extending through the insulator material towards the support structure a comprising a second electrically conductive material in the second opening, wherein:
the bitline is further coupled to a source region or a drain region of a transistor of the third floating body memory cell,
the second electrically conductive material in the second opening is a part of the second wordline, and
the second wordline is coupled to or is a part of a gate of the transistor of the third floating body memory cell.

8. An integrated circuit (IC) device, comprising:
an insulator material over a substrate;
a first opening extending through the insulator material towards the substrate and having a first channel material on sidewalls of the first opening;
a second opening extending through the insulator material towards the substrate and having a second channel material on sidewalls of the second opening;
a first transistor having a channel region in a first portion of the first channel material;
a second transistor having a channel region in a second portion of the first channel material, the second portion being further away from the substrate than the first portion; and
a third transistor having a channel region in a portion of the second channel material,
wherein a first source or drain (S/D) region of the first transistor is coupled to a first control line, a first S/D region of the second transistor is coupled to a second control line, a first S/D region of the third transistor is coupled to a third control line, and a second S/D region of the first transistor, a second S/D region of the second transistor and a second S/D region of the third transistor are coupled to a fourth control line.

9. The IC device according to claim 8, wherein the first opening is at least partially filled with a first conductive material, the second opening is at least partially filled with a second conductive material, the first conductive material is a part of a gate stack of the first transistor and a part of a gate stack of the second transistor, and the second conductive material is a part of a gate stack of the third transistor.

10. The IC device according to claim 9, wherein the first conductive material in the first opening is a fifth control line, and the second conductive material in the second opening is a sixth control line.

11. The IC device according to any one of claims 8-10, wherein the first control line, the second control line, and the third control line are substantially parallel to one another and substantially parallel to the substrate.

12. The IC device according to any one of claims 8-11, wherein the first control line and the fourth control line are substantially perpendicular to the first opening and substantially perpendicular to one another.

13. The IC device according to any one of claims 8-12, wherein the first transistor is a first floating body memory cell, the second transistor is a second floating body memory cell, and the third transistor is a third floating body memory cell.

14. An integrated circuit (IC) device, comprising:
a die;
a semiconductor material in a layer substantially parallel to the die;
first, second, third, and fourth transistors having channel regions in different portions of the semiconductor material;
first, second, third, and fourth control lines coupled to, respectively, gates of the first, second, third, and fourth transistors;
a fifth control line coupled to a first region of each of the first, second, third, and fourth transistors; and
a sixth control line coupled to a second region of each of the first, second, third, and fourth transistors, wherein one of the first region and the second region is a source region and another one of the first region and the second region is a drain region.

15. The IC device according to claim 14, wherein the first, second, third, and fourth control lines are substantially parallel to one another and to the die.
